# EUROPEAN PATENT APPLICATION

(11) **EP 4 357 492 A1**
(43) Date of publication of application: **24.04.2024**
(21) Application number: 22824748.2
(22) Date of filing: 24.05.2022
(51) Int. Cl.: C30B 29/04

(54) **DIAMOND SUBSTRATE AND MANUFACTURING METHOD FOR SAME**

(30) Priority: 16.06.2021 JP 2021100501
(71) Applicant: SHIN-ETSU CHEMICAL CO., LTD., Tokyo 1000005 (JP); National Institute of Advanced Industrial Science and Technology, Chiyoda-ku Tokyo 100-8921 (JP)
(72) Inventor: NOGUCHI, Hitoshi, Annaka-shi, Gunma 379-0195 (JP); MAKINO, Toshiharu, Tsukuba-shi, Ibaraki 305-8568 (JP); OGURA, Masahiko, Tsukuba-shi, Ibaraki 305-8568 (JP); KATO, Hiromitsu, Tsukuba-shi, Ibaraki 305-8568 (JP)
(74) Representative: Sonnenhauser, Thomas Martin
(86) International application number: PCT/JP2022/021218
(87) International publication number: WO 2022/264754

(57) **Abstract**

The present invention provides a method for manufacturing a diamond substrate, the method being a method for producing a (111) oriented diamond crystal on an underlying substrate by epitaxial growth using hydrogen-diluted methane as a main source gas by a microwave plasma CVD method, a direct current plasma CVD method, a hot-filament CVD method, or an arc discharge plasma jet CVD method, in which a growth rate is less than 3.8 µm / h. Thereby, a diamond crystal applicable to an electronic and magnetic device and a method to produce this crystal are stably provided in which the crystal with the NV axis with [111] orientation and high-density NVC obtained by the CVD method under a predetermined condition is grown on a highly oriented (111) diamond base substrate obtained by the CVD method also under a predetermined condition.

## Description

### TECHNICAL FIELD

The present invention relates to a diamond substrate and a method for manufacturing the substrate.

### BACKGROUND ART

Diamond has a wide bandgap of 5.47 eV at room temperature and is known as a wide bandgap semiconductor.

Among wide bandgap semiconductors, diamond has an extremely high dielectric breakdown electric field strength of 10 MV/cm, and a high-voltage operation can be performed. In addition, diamond has the highest thermal conductivity among known materials and an excellent heat radiation property. Further, diamond has very large carrier mobility and saturated drift velocity and is suitable for a high-speed device.

Accordingly, diamond has the highest Johnson performance index, indicating a property as a radio-frequency and high-power device, compared to semiconductors such as silicon carbide and gallium nitride, and is said to be an ultimate semiconductor.

Further, diamond has nitrogen-vacancy center (NVC) within the crystal, can manipulate and detect a single spin at room temperature, and has the characteristic that the condition can be imaged by photodetection magnetic resonance. Making use of this characteristic, application in a wide field of high-sensitivity sensors for a magnetic field, electric field, temperature, pressure, etc., is expected.

### CITATION LIST

### PATENT LITERATURE

Patent Document 1: US 2013/0143022 A1
Patent Document 2: JP 2020-090408 A

### NON PATENT LITERATURE

Non Patent Document 1: M. Hatano et al., OYOBUTURI 85, 311 (2016)

### SUMMARY OF INVENTION

### TECHNICAL PROBLEM

As described above, diamond is expected to be used practically as material for semiconductors or material for electronic and magnetic devices, and the supply of a diamond substrate with a large area and high quality is desired. In particular, for use in an NVC device of high importance, the NV axis has to be highly oriented, and therefore, the diamond surface is preferably a (111) crystal surface with the NV axis aligned in a [111] direction (Non Patent Document 1).

In addition, for example, considering application in an MRI field for medical purposes, a device that can measure a broader range efficiently can be realized with the diamond substrate with a large diameter as the magnetic sensor portion. In addition, there is an advantage considering manufacturing costs.

Patent Document 1 discloses a technique to form a diamond (111) crystal by heteroepitaxial growth using a chemical vapor deposition (CVD) method. However, it is unclear whether a finished size or the characteristic has a satisfactory level.

Hence, one of the inventors of the present invention has invented a laminate substrate including a single crystal diamond (111) applicable to an electronic and magnetic device with a large diameter and high quality, a single crystal diamond (111) freestanding substrate with a large diameter, and a method for manufacturing the laminate substrate and a method for manufacturing the freestanding substrate (Patent Document 2).

Unfortunately, a problem has become apparent in a reproducibility of crystal orientation when a single crystal diamond (111) is formed with a thickness of 80 um or more or crystal growth is repeated.

For example, even if a heterodiamond (111) is used for a base substrate, an orientation sometimes has changed to (001) during crystal growth. Whether an undoped diamond is used as a base diamond layer or an N-doped diamond is used as an NVC layer, the problem of a changing orientation has occurred.

The present invention has been made in view of the above-described problem. An object of the present invention is to stably provide a diamond crystal applicable to an electronic and magnetic device and a method to produce this crystal in which the crystal has an NV axis with [111] orientation and a high-density NVC obtained by the CVD method under a predetermined condition grown on a highly oriented (111) diamond base substrate obtained by the CVD method also under a predetermined condition.

### SOLUTION TO PROBLEM

To solve the problem described above, the present invention provides a method for manufacturing a diamond substrate, the method being a method for producing a (111) oriented diamond crystal on an underlying substrate by epitaxial growth using hydrogen-diluted methane as a main source gas by a microwave plasma CVD method, a direct current plasma CVD method, a hot-filament CVD method, or an arc discharge plasma jet CVD method in which a growth rate is less than 3.8 µm/h.

Such a method for manufacturing the diamond substrate can stably provide a diamond crystal applicable to an electronic and magnetic device and the method to produce this crystal. This crystal has the NV axis with [111] orientation and the high-density NVC obtained by the CVD method under a predetermined condition on a highly oriented (111) diamond base substrate obtained by the CVD method also under a predetermined condition.

In this case, a (111) oriented nitrogen-doped diamond crystal can be produced on the underlying substrate using hydrogen-diluted methane as the main source gas and adding a nitrogen gas as a dopant at the method for producing the (111) oriented diamond crystal by epitaxial growth.

Such a method for manufacturing the diamond substrate can more stably provide the diamond crystal applicable to the electronic and magnetic device, in which the NV axis with [111] orientation and the high-density NVC are obtainable, and the method for producing the crystal.

In this case, a temperature of the underlying substrate being grown by the microwave plasma CVD method, the direct current plasma CVD method, the hot-filament CVD method, or the arc discharge plasma jet CVD method is preferably within a range of 600°C to 1050°C.

Such a temperature range is preferable because non-diamond phases such as amorphous carbon and graphite do not grow, the growth rate is not too high, (111) growth can follow, and (001) growth is not dominant.

In this case, the underlying substrate can be a single layer substrate of a single crystal diamond (111) .

Such an underlying substrate is preferable because the diamond substrate with higher quality is manufacturable.

In this case, the underlying substrate is preferably the single crystal diamond (111) and has a main surface that has an off angle within a range, -8.0° or more and -0.5° or less, or +0.5° or more and +8.0° or less in a crystal axis [-1-1 2] direction or a threefold symmetry direction thereof relative to a crystal plane orientation of (111).

Having an off angle within such a range is preferable because step-flow growth is facilitated, and a resulting single-crystal diamond layer with high quality has little hillock, abnormal growth particles, dislocation defect, and the like.

In this case, the underlying substrate, including the single crystal diamond (111), can be a high-pressure-high-temperature-synthesized single crystal diamond, a heteroepitaxial single crystal diamond, a CVD-synthesized homoepitaxial diamond, and a combined single crystal diamond thereof.

Such an underlying substrate is preferable because the diamond substrate with much higher quality is manufacturable.

Additionally, in the present invention, the underlying substrate can have a laminated structure, including an underlayer substrate and an intermediate layer on the underlayer substrate.

Such an underlying substrate is preferable because the diamond substrate with even higher quality is manufacturable.

In this case, the intermediate layer can have an outermost surface being a metal layer selected from Ir, Rh, Pd, Pt, Cu, Ni, Fe, Cr, Mn, and Ti.

Using such a metal layer is preferable because of the facilitated formation of high-density diamond nuclei during a nucleation process (bias treatment) and a facilitated formation of a single-crystal diamond layer on top of the diamond nuclei.

In this case, the underlayer substrate can be a substrate including a single Si, MgO, Al₂O₃, SiO₂, Si₃N₄, SiC, Ir, Rh, Pd, Pt, Cu, Ni, Fe, Cr, Mn or Ti, or a laminated body selected from Si, MgO, Al₂O₃, SiO₂, Si₃N₄, SiC, Ir, Rh, Pd, Pt, Cu, Ni, Fe, Cr, Mn or Ti.

These materials can easily configure the crystal plane orientation (including an off angle) on the main surface of the underlying substrate and are relatively inexpensive, easily available, and thus preferable.

In this case, the underlayer substrate can have a main surface with a plane orientation of (111) or further include a layer with a main surface of a plane orientation of (111) between the underlayer substrate and the intermediate layer.

Such a method for manufacturing the diamond substrate enables more efficient epitaxial growth and is thus preferable.

In this case, the main surface with the plane orientation of (111) of the underlayer substrate can have an off angle within a range, -8.0° or more and - 0.5° or less, or +0.5° or more and +8.0° or less in a crystal axis [-1-1 2] direction or a threefold symmetry direction thereof relative to a crystal plane orientation of (111).

Having the off angle within such a range is preferable because step-flow growth is facilitated, and a resulting single-crystal diamond layer with high quality has little hillock, abnormal growth particles, dislocation defect, and the like.

Moreover, in the present invention, a total thickness of a diamond formed on the underlying substrate can be 80 to 2000 um according to the method for manufacturing the diamond substrate.

With such a total thickness, a (111) highly oriented crystal is easily obtainable and is thus preferable.

Furthermore, in the present invention, a member containing Si is preferably not used in a chamber for performing the CVD method according to the method for manufacturing the diamond substrate.

Such a method for manufacturing the diamond substrate is preferable because of preventing the mixture of Si into the diamond crystal.

In this case, sapphire is preferably used for an observation window of the chamber used for the CVD method.

Such a method for manufacturing the diamond substrate is also preferable because of the prevention of the mixture of Si into the diamond crystal.

Additionally, in the present invention, a (111) oriented diamond substrate can be obtained by removing the underlying substrate from a laminate substrate, including the (111) oriented diamond crystal obtained by the method for manufacturing the diamond substrate.

Such a method for manufacturing the diamond substrate is preferable for providing a diamond substrate with freestanding structure and reducing a cause of noise in actual use.

Moreover, in the present invention, a (111) oriented diamond substrate can also be obtained by removing the underlying substrate, the underlayer substrate, or both the intermediate layer and the underlayer substrate from a laminate substrate, including the (111) oriented diamond crystal obtained by the method for manufacturing the diamond substrate.

Such a method for manufacturing the diamond substrate is also preferable for providing a diamond substrate with freestanding structure and reducing a cause of noise in actual use.

Furthermore, in the present invention, a surface of the (111) oriented diamond crystal obtained by the method for manufacturing the diamond substrate is preferably smoothed.

Such a method for manufacturing the diamond substrate makes the diamond substrate more suitable for a substrate for the electronic and magnetic device and is thus preferable.

In addition, the present invention provides a diamond substrate, wherein
a (111) plane diffracted peak is detected while a (111) plane is being oriented toward a substrate main surface normal direction, whereas
a (111) plane diffracted peak is undetected while a (001) plane is being oriented toward a substrate main surface normal direction, wherein
   an X-ray diffractometer is used by a pole figure method with an anticathode Cu being used as an X-ray generator under a condition of a power 45 kV of 200 mA, an evaluating diffracted plane (111), a diffracted angle 2Θ = 43.9°, and a step size of 1°.

Such a diamond substrate includes the diamond crystal applicable to the electronic and magnetic device. This crystal has an NV axis with [111] orientation and a high-density NVC obtained by the CVD method under a predetermined condition on a highly oriented (111) diamond base substrate obtained by the CVD method also under a predetermined condition.

In this case, a rocking curve half width of the diamond substrate is preferably 0.90° or less, wherein
an X-ray diffractometer is used by an Out-of-plane method with an anticathode Cu being used as an X-ray generator under a condition of a power 45 kV of 200 mA, an evaluating diffracted plane (111), a diffracted angle 2Θ = 43.9°, and a step size of 0.001°.

Such a diamond substrate can be made of a higher-quality diamond crystal.

### ADVANTAGEOUS EFFECTS OF INVENTION

As described above, according to the inventive method for manufacturing the diamond substrate, it is possible to provide the diamond substrate applicable to the electronic and magnetic device with a high crystalline, an NV axis with [111] high orientation, and a high-density NVC on a high-pressure-high-temperature (HPHT), heteroepitaxial and homoepitaxial diamond base substrate.

Moreover, the inventive diamond substrate is the diamond substrate applicable to the electronic and magnetic device with the high crystalline, the NV axis with [111] high orientation, and the high-density NVC.

### BRIEF DESCRIPTION OF DRAWINGS

FIG. 1 is a view illustrating an example of a formation of a (111) oriented nitrogen-doped diamond crystal on an underlying substrate of a single layer substrate according to the present invention.
FIG. 2 is a view illustrating an example of a formation of a (111) oriented nitrogen-doped diamond crystal on an underlying substrate of a laminated structure according to the present invention.
FIG. 3 is a view illustrating an example of a formation of a (111) oriented diamond crystal and a (111) oriented nitrogen-doped diamond crystal on an underlying substrate of the laminated structure according to the present invention.
FIG. 4 is a view illustrating an example of a diamond substrate remaining with a (111) oriented nitrogen-doped diamond crystal/(111) oriented diamond crystal according to the present invention.
FIG. 5 is a view describing a plane orientation.
FIG. 6 is a view showing a measurement result of a polished nitrogen-undoped single crystal (111) oriented diamond substrate according to a pole figure method by XRD in Example 1.
FIG. 7 is a view showing a three-dimensional display of a measurement result of a polished nitrogen-undoped single crystal (111) oriented diamond substrate according to a pole figure method by XRD in Example 1.
FIG. 8 is a view showing a fluorescence spectrum of a (111) oriented nitrogen-doped diamond crystal at an excitation light wavelength of 532 nm in Example 1.
FIG. 9 is a view showing a result of analysis by an Electron Backscatter Diffraction (EBSD) method.

### DESCRIPTION OF EMBODIMENTS

As described above, it has been required to obtain stably a diamond substrate with a diamond crystal of (111) high orientation, an NV axis with [111] high orientation when doped with nitrogen, and a high-density NVC for an electronic and magnetic device.

To solve the above problem, the present inventors have earnestly studied and found out an inventive method for manufacturing the diamond substrate that can stably provide the diamond crystal applicable to the electronic and magnetic device and a method to produce this crystal, in which the crystal has an NV axis with [111] orientation and a high-density NVC obtained by a CVD method under a predetermined condition on a highly oriented (111) diamond base substrate obtained by a CVD method also under a predetermined condition. This finding has led to the completion of the present invention.

In other words, the present invention is a method for manufacturing a diamond substrate, the method being a method for producing a (111) oriented diamond crystal on an underlying substrate by epitaxial growth using hydrogen-diluted methane as a main source gas by a microwave plasma CVD method, a direct current plasma CVD method, a hot-filament CVD method, or an arc discharge plasma jet CVD method in which a growth rate is less than 3.8 µm/h.

Hereinafter, the present invention will be described in detail. However, the present invention is not limited thereto.

Hereinafter, a description will be given with reference to the drawings.

To begin with, terms used in this Description are defined.

In this Description, a crystal layer or a crystal film having a main surface with a (111) plane is simply referred to as a "(111) layer" or "(111) film". For example, a single crystal diamond layer having a main surface with a (111) plane is referred to as a "single crystal diamond (111) layer.

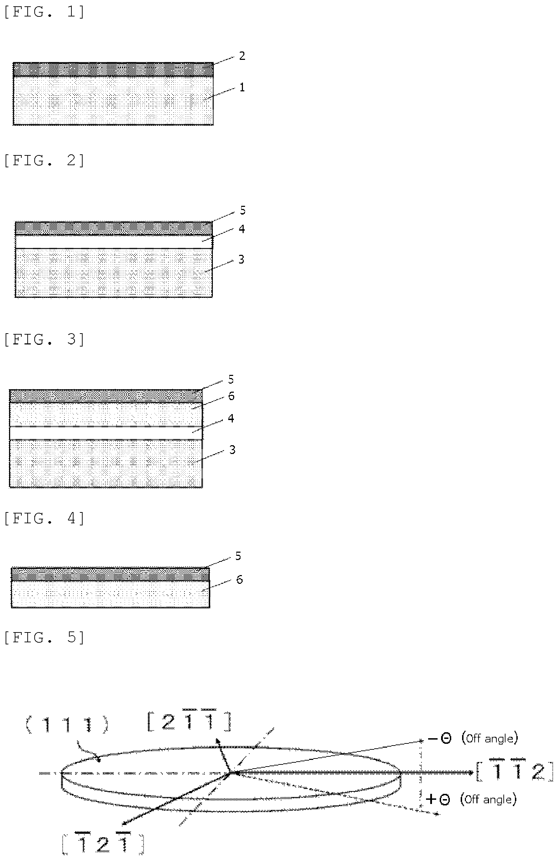

Moreover, a relation concerning an off angle is shown in FIG. 5. FIG. 5 shows a conceptual diagram of a [-1-1 2] direction and threefold symmetry directions thereof, [-1 2-1], [2-1-1], and off angles, for a substrate with a (111) plane as a main plane. Moreover, a [112] direction is denoted as [-1-1 2] direction in this Description.

### (Diamond substrate)

The present invention provides a diamond substrate, in which a (111) plane diffracted peak is detected while a (111) plane is being oriented toward a substrate main surface normal direction, whereas a (111) plane diffracted peak is undetected while a (001) plane is being oriented toward a substrate main surface normal direction, in which an X-ray diffractometer is used by a pole figure method with an anticathode Cu being used as an X-ray generator under a condition of a power 45 kV of 200 mA, an evaluating diffracted plane (111), a diffracted angle 2Θ = 43.9°, and a step size of 1°.

In this case, a rocking curve half width of the diamond substrate is preferably 0.90° or less, in which an X-ray diffractometer is used by an Out-of-plane method with an anticathode Cu being used as an X-ray generator under a condition of a power 45 kV of 200 mA, an evaluating diffracted plane (111), a diffracted angle 2Θ = 43.9°, and a step size of 0.001°. A lower limit of the rocking curve half width is not particularly limited but can be 0.01° or more, for example.

Such a high-quality diamond substrate with an NV axis with [111] high orientation and a high-density NVC is applicable to the electronic and magnetic device and is producible by a following method.

### (Method for manufacturing diamond substrate)

The present invention is a method for manufacturing a diamond substrate, the method being a method for producing a (111) oriented diamond crystal on an underlying substrate by epitaxial growth using hydrogen-diluted methane as a main source gas by a microwave plasma CVD method, a direct current plasma CVD method, a hot-filament CVD method, or an arc discharge plasma jet CVD method, in which a growth rate is less than 3.8 µm/h.

If the growth rate is 3.8 µm/h or more, a desired (111) highly oriented crystal cannot be obtained because a crystal growth mode changes from a (111) oriented growth to a (001) oriented growth.

By contrast, if the growth rate is kept under 3.8 pm/h, the growth continues maintaining the (111) orientation thus the desired (111) highly oriented crystal can be obtained. Moreover, 3.3 µm/h or less is preferable because of more stable crystal growth. The lower the growth rate, the more preferable, and a lower limit is not particularly limited but can be 0.1 µm/h or higher.

In this case, a (111) oriented nitrogen-doped diamond crystal can be produced on the underlying substrate using hydrogen-diluted methane as the main source gas and adding a nitrogen gas as a dopant in accordance with the method for producing the (111) oriented diamond crystal by epitaxial growth.

In this case, a temperature of the underlying substrate being grown by the microwave plasma CVD method, the direct current plasma CVD method, the hot-filament CVD method, or the arc discharge plasma jet CVD method is preferably within a range of 600°C to 1050°C.

If the temperature is 600°C or higher, non-diamond phases such as amorphous carbon and graphite do not grow. If the temperature is 1050°C or lower, the growth rate is not too high, (111) growth can follow, and (001) growth is not dominant.

In this case, the underlying substrate can be a single layer substrate of a single crystal diamond (111) .

FIG. 1 shows a substrate in which a (111) oriented nitrogen-doped diamond crystal 2 (NVC containing diamond layer) is formed on the underlying substrate 1.

In this case, the underlying substrate is preferably the single crystal diamond (111) and has a main surface that has an off angle within a range, -8.0° or more and -0.5° or less, or +0.5° or more and +8.0° or less in a crystal axis [-1-1 2] direction or a threefold symmetry direction thereof relative to a crystal plane orientation of (111).

Having the off angle within such a range makes step-flow growth facilitated, and a resulting single-crystal diamond layer with high quality has little hillock, abnormal growth particles, dislocation defects, and the like.

In this case, the underlying substrate, including the single crystal diamond (111), can be any of a high-pressure-high-temperature-synthesized single crystal diamond, a heteroepitaxial single crystal diamond, a CVD-synthesized homoepitaxial diamond, and a combined single crystal diamond thereof.

Additionally, in the present invention, the underlying substrate can also have a laminated structure, including an underlayer substrate and an intermediate layer on the underlayer substrate.

FIG. 2 shows a substrate in which a (111) oriented nitrogen-doped diamond crystal 5 is formed on the underlying substrate having a laminated structure (an underlayer substrate 3, an intermediate layer 4)

The intermediate layer may be a single layer or a laminate having a plurality of layers. The intermediate layer preferably has an outermost surface, being a metal layer selected from Ir, Rh, Pd, Pt, Cu, Ni, Fe, Cr, Mn, and Ti. The use of such a metal layer is preferable because of a facilitated formation of high-density diamond nuclei during a nucleation process (bias treatment) and a facilitated formation of a single-crystal diamond layer on top of the diamond nuclei.

In this case, the underlayer substrate can be a substrate including a single Si, MgO, Al₂O₃, SiO₂, Si₃N₄, SiC, Ir, Rh, Pd, Pt, Cu, Ni, Fe, Cr, Mn or Ti, or a laminated body selected from Si, MgO, Al₂O₃, SiO₂, Si₃N₄, SiC, Ir, Rh, Pd, Pt, Cu, Ni, Fe, Cr, Mn or Ti.

These materials can easily configure the crystal plane orientation (including the off angle) on the main surface of the underlying substrate. Moreover, these materials are relatively inexpensive and easily available.

Understandably, as the underlying substrate, the substrate configured by the underlayer substrate and the intermediate layer of the same material used for both is also included. Moreover, a substrate including a single material from Ir, Rh, Pd, Pt, Cu, Ni, Fe, Cr, Mn, or Ti may be used as the underlying substrate.

In this case, the underlayer substrate can have a main surface with a plane orientation of (111) or further include a layer having a main surface with a plane orientation of (111) between the underlayer substrate and the intermediate layer.

Such a substrate can make epitaxial growth more efficient.

In this case, the main surface with the plane orientation of (111) of the underlayer substrate can have an off angle within a range, -8.0° or more and - 0.5° or less, or +0.5° or more and +8.0° or less in a crystal axis [-1-1 2] direction or a threefold symmetry direction thereof relative to a crystal plane orientation of (111).

Having the off angle within such a range makes step-flow growth facilitated, and a resulting single-crystal diamond layer with high quality can have little hillock, abnormal growth particles, dislocation defects, and the like.

In a range where the off angle is greater than - 0.5° and less than +0.5, since the growth toward a step direction is difficult, a crystal with excellent quality is unobtainable. Besides, in a range where the off angle is less than -8.0° and greater than +8.0°, growth over a long time results in polycrystallization, and an excellent quality single crystal cannot be obtained.

Moreover, in the present invention, a total thickness of a diamond formed on the underlying substrate can be 80 to 2000 um according to the method for manufacturing the diamond substrate.

With such a total thickness, a (111) highly oriented crystal is easily obtained.

The thickness of 80 um or more has fewer dislocation defects and a higher orientation. On the other hand, with the thickness of 2000 um or less, a growth location with respect to plasma is the same as the initial growth location, thus, a rise in a substrate temperature and an increase in the growth rate do not occur. As a result, an abnormal growth does not increase.

A typical CVD apparatus to manufacture the diamond substrate uses stainless steel for an inner wall of a chamber, stainless steel and molybdenum for such as a stage, Si₃N₄, SiC, Al₂O₃, BN, etc. for such as an insulator, and SiO₂ for an observation window. When producing the diamond by such a typical CVD apparatus, Si is mixed into the diamond crystal, forming a silicon-vacancy center (SiVC) and becoming a noise source when the diamond substrate is used for an electronic and magnetic sensor.

Consequently, in the present invention, a member containing Si is preferably not used in a chamber for performing the CVD according to the method for manufacturing the diamond substrate described above.

In particular, it is considered that a source of mixing Si is the observation window of the chamber for performing the CVD. Consequently, sapphire is preferably used for the observation window of the chamber for performing the CVD.

Moreover, in the present invention, a (111) oriented diamond substrate can be obtained by removing the underlying substrate from a laminate substrate, including the (111) oriented diamond crystal obtained by the method for manufacturing the diamond substrate.

Moreover, in the present invention, a (111) oriented diamond substrate can be obtained by removing the underlying substrate, the underlayer substrate, or both the intermediate layer and the underlayer substrate from a laminate substrate, including the (111) oriented diamond crystal obtained by the method for manufacturing the diamond substrate.

The diamond substrate with an increased ratio of an NVC-containing portion reduces the cause of noise in practical usage, and therefore, a high-sensitivity electronic and magnetic device can be realized.

FIG. 3 shows the diamond substrate where a (111) oriented diamond crystal 6 and the (111) oriented nitrogen-doped diamond crystal 5 are formed sequentially on the underlying substrate having the laminated structure (the underlayer substrate 3, the intermediate layer 4).

FIG. 4 shows a case where the underlying substrate is removed, and then a freestanding structure substrate is made of the (111) oriented nitrogen-doped diamond crystal 5/(111) oriented diamond crystal 6.

Furthermore, in the present invention, a surface of the (111) oriented diamond crystal obtained by the method for manufacturing the diamond substrate is preferably smoothed.

For smoothing, mechanical polishing, chemical/mechanical polishing, plasma treatment, sputtering treatment, and chemical etching can preferably be performed.

### EXAMPLE

Hereinafter, the present invention will be specifically described with reference to Examples and Comparative Examples. However, the present invention is not limited thereto.

### (Example 1)

As an underlying substrate, a single-side polished single crystal MgO substrate (hereafter referred to as "single crystal MgO (111) substrate") was provided with a diameter of 20.0 mm, a thickness of 1.0 mm, a main surface of (111) orientation, and an off angle with +4° in a crystal axis [-1-1 2] direction relative to a crystal plane orientation of (111).

Then, an intermediate layer of a single crystal Ir film was formed on the surface of the provided single crystal MgO (111) substrate by a radio-frequency (RF) magnetron sputtering method. The single crystal Ir film was formed by a radio-frequency (RF) magnetron sputtering method (13.56 MHz) with targeting at Ir having a diameter of 6 inches (150 mm), a thickness of 5.0 mm, and purity of 99.9% or more.

The single crystal MgO (111) substrate, being an underlayer substrate, was heated to 800°C, and after it was confirmed that the base pressure had become 6×10⁻⁷ Torr (about 8.0×10⁻⁵ Pa) or lower, 50 sccm of Ar gas was introduced. Next, after making the pressure 3×10⁻¹ Torr (about 39.9 Pa) by adjusting the aperture of the valve connected to the exhaust system, film formation was performed for 15 minutes by inputting an RF power of 1000 W. In this manner, a single crystal Ir film with a thickness of 1.0 um was obtained.

A single crystal MgO (111) substrate on which a single crystal Ir film was laminated (an Ir (111) film/single crystal MgO (111) substrate) in the manner described above grew heteroepitaxially in accordance with the off angle of the single crystal MgO (111) substrate. This single crystal Ir film was analyzed by an Out-of-plane X-ray diffraction method with a wavelength of λ = 1.54 Å, and as a result, the surface was a (111) plane, and there was an off angle of +4° in the crystal axis [-1-1 2] direction relative to a crystal plane orientation of (111). In addition, the half width (FWHM) of the diffracted peak at 2Θ = 40.7°, assigned to Ir (111), was 0.142°. Hereinafter, this single crystal Ir film will be referred to as "Ir (111) film".

Next, as a pre-treatment for forming diamond nuclei, a nucleation treatment (bias treatment) was performed. The Ir (111) film/single crystal MgO (111) substrate was set on a planar electrode with a diameter of 25 mm inside a treatment chamber with the Ir (111) film side facing upwards. After it was confirmed that the base pressure had become 1×10⁻⁶ Torr (about 1.3×10⁻⁴ Pa) or lower, hydrogen-diluted methane gas (CH₄/(CH₄+H₂) = 5.0 vol.%) was introduced into the treatment chamber at a flow rate of 500 sccm. After making the pressure 100 Torr (about 1.3×10⁴ Pa) by adjusting the aperture of the valve connected to the exhaust system, a negative voltage was applied to the electrode at the Ir (111) film/single crystal MgO (111) substrate side to expose to plasma for 90 seconds, and thereby the Ir (111) film surface of the Ir (111) film/single crystal MgO (111) substrate was subjected to bias treatment.

A (111) oriented diamond crystal was heteroepitaxially grown on the Ir (111) film/single crystal MgO (111) substrate produced as described above by a microwave plasma CVD method. The Ir (111) film/single crystal MgO (111) substrate subjected to bias treatment was set inside the chamber of a microwave plasma CVD apparatus. After it was confirmed that the base pressure had become 1×10⁻⁶ Torr (about 1.3×10⁻⁴ Pa) or lower, a temperature of the substrate was set to 860 to 970°C, a mixed gas of methane gas and hydrogen gas, the mixed gas being a raw material, was introduced into the chamber at a flow rate of 500 sccm at the following volume ratio:
methane gas: 3.0000 vol.%, and
hydrogen gas: 97.0000 vol.%.
After making the pressure inside the chamber 110 Torr (about 1.5×10⁴ Pa) by adjusting the aperture of the valve connected to the exhaust system, film formation was performed for 99 hours by applying a microwave of 3500W, whereby the film formation was performed until the thickness reached about 140 um (a growth rate: 1.4 µm/h).

In this manner, the (111) oriented diamond crystal was heteroepitaxially grown on the Ir (111) film/single crystal MgO (111) substrate, and a laminate substrate was obtained.

Subsequently, the Ir (111) film/single crystal MgO (111) substrate was removed to make a freestanding substrate. Firstly, after removing the single crystal MgO (111) substrate by etching, the Ir (111) film was removed by polishing. As a result, the freestanding substrate (a (111) oriented diamond substrate) having a diameter of 20 mm and being made of the (111) oriented diamond crystal of 140 um was obtained.

A surface of the (111) oriented diamond crystal of the (111) oriented diamond substrate was processed by scaife polishing to smooth and mirror finish. When the surface of the (111) oriented diamond crystal was measured in a 290 µm×218 um region using an optical surface roughness tester (New View 5032 manufactured by Zygo Corporation), the average surface roughness Ra was 0.4 (nm) (a polished nitrogen-undoped single crystal (111) oriented diamond substrate).

Then, the polished nitrogen-undoped single crystal (111) oriented diamond substrate was measured with an X-ray diffraction analysis.

Crystallinity was measured from the outermost surface of the crystal with an X-ray diffraction (XRD) apparatus (SmartLab manufactured by Rigaku Corporation, an X-lay wavelength of λ=1.54Å).

Firstly, a crystal orientation was observed with a pole figure method. A surface of a sample was set on a stage facing upward and measured while the sample was being moved in the diameter direction (α) and circumferential direction (β), with an anticathode Cu being used as an X-ray generator under a condition of a power 45 kV of 200 mA, an evaluating diffracted plane (111), a diffracted angle 2θ = 43.9°, and a step size of 1°.

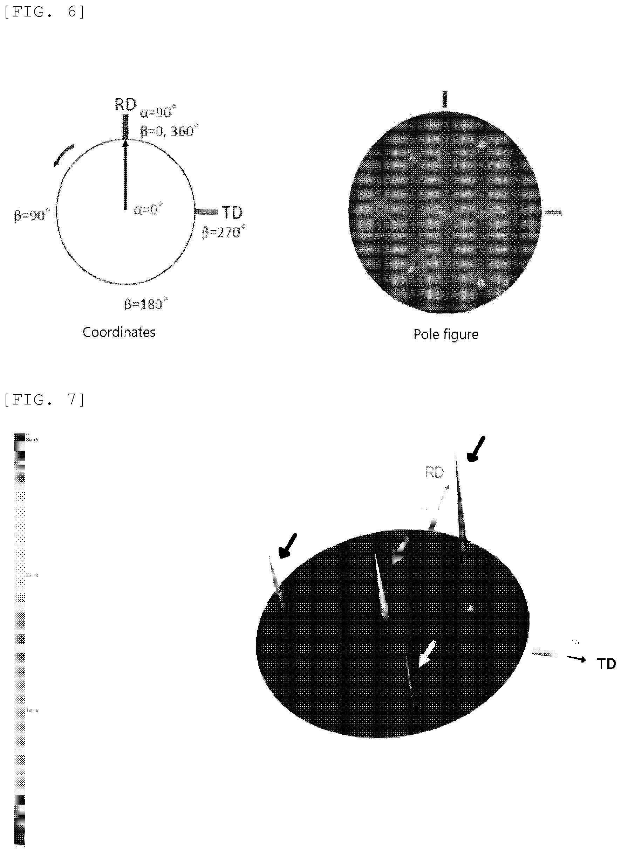

As a result, a (111) plane diffracted peak was detected while a (111) plane was being oriented toward a substrate main surface normal direction, whereas a (111) plane diffracted peak was undetected while a (001) plane was being oriented toward a substrate main surface normal direction. The result is shown in FIG. 6.

As shown in FIG. 6, a (111) plane diffracted peak was detected in the vicinity of α=0°, β=0° while a (111) plane is being oriented toward a substrate main surface normal direction. Moreover, a (111) plane diffracted peak was detected in the vicinity where α=70.6° and β is in an interval of 120° while the (111) plane is being oriented toward a substrate main surface side direction. FIG. 7 shows a three-dimensional display of a result of FIG. 6. Obviously, a crystal with a (111) orientation was detected.

On the other hand, a (111) plane diffracted peak was detected where α=54.7° and β is in an interval of 90° while a (001) plane is being oriented toward a substrate main surface normal direction. However, the peak was not detected in the polished nitrogen-undoped single crystal (111) oriented diamond substrate of the present invention.

Secondly, the same XRD apparatus described above was used, and a crystal orientation was observed according to the Out-of-plane method. A rocking curve was measured with the anticathode Cu being used as the X-ray generator under the condition of the power 45 kV of 200 mA, the evaluating diffracted plane (111), the diffracted angle 2Θ = 43.9°, an incident angle ω = 23 to 29°, the step size of 0.001°, and a scan rate of 1°/min. As a result, the off angle was +5°, and the rocking curve half width was 0.665°.

Consequently, the polished nitrogen-undoped single crystal (111) oriented diamond substrate was a (111) highly oriented crystal. When such a substrate is applied to the electronic and magnetic device, a high-performance device can be obtained.

Furthermore, the polished nitrogen-undoped single crystal (111) oriented diamond substrate was then subjected to a mixture of methane gas, hydrogen gas, and further nitrogen gas by the microwave plasma CVD method described above, and the mixed gas was introduced into the chamber at a flow rate of 500 sccm at the following volume ratio:
methane gas: 0.4000 vol.%,
hydrogen gas: 99.5995 vol.%, and
nitrogen gas: 0.0005 vol.%.
A microwave was applied and kept the same at 3500W, making the pressure 110 Torr (about 1.5×10⁴ Pa) with pressurizing for 8 hours. The substrate temperature was set to 680°C, then the film formation was performed under the conditions for 5 hours until a nitrogen-doped layer (a (111) oriented nitrogen-doped diamond crystal) had a thickness of about 8 um (growth rate: 1.6 µm/h). This way, a (111) oriented nitrogen-doped diamond crystal/polished nitrogen-undoped single-crystal (111) oriented diamond laminate substrate was obtained.

Lastly, the completed (111) oriented nitrogen-doped diamond crystal/polished nitrogen-undoped single-crystal (111) oriented diamond laminate substrate was analyzed by SIMS and PL, respectively.

Nitrogen concentration [N] in the (111) oriented nitrogen-doped diamond crystal/polished nitrogen-undoped single-crystal (111) oriented diamond laminate substrate was measured with a secondary ion mass spectrometry (SIMS) apparatus (IMS-7f manufactured by CAMECA). As a result, a nitrogen concentration [N] of the (111) oriented nitrogen-doped diamond crystal/polished nitrogen-undoped single-crystal (111) oriented diamond laminate substrate at a depth of about 8 um from the outermost surface was [N] = 6×10¹⁷ atoms/cm³.

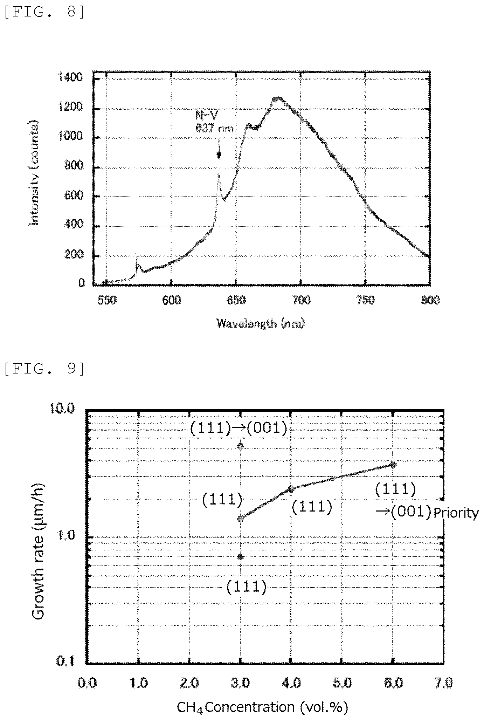

Furthermore, a photoluminescence (PL) apparatus (NRS-4500 manufactured by JASCO Corporation) was used for measurement under the conditions: an excitation light wavelength of 532 nm; an excitation light intensity of 0.02 mW; a total time of 1 second; a total number of 3 times; an objective lens with a magnification of 100; and measurement in a room temperature (about 298 K). As a result, a sharp peak of NV-center (NVC) light (a wavelength of 637 nm) was observed. By contrast, a silicon-vacancy center light (a wavelength of 738 nm) was not detected. The result is shown in FIG. 8.

Consequently, a (111) oriented nitrogen-doped diamond crystal obtained was the (111) oriented nitrogen-doped diamond crystal formed with the NV axis with [111] orientation and the NVC of high density. Applying the (111) oriented nitrogen-doped diamond crystal to the electronic and magnetic device provides a high-performance device. For example, a magnetic sensor with high sensitivity can be obtained.

### (Example 2)

A polished nitrogen-undoped single-crystal (111) oriented diamond substrate was manufactured as in Example 1, except that a substrate temperature was 800 to 850°C, a time for film-formation was 45 hours, and a growth rate was 0.7 µm/h.

### (Example 3)

A polished nitrogen-undoped single-crystal (111) oriented diamond substrate was manufactured as in Example 1, except that a substrate temperature was 860 to 1020°C, a mixed gas of methane gas and hydrogen gas, the mixed gas being a raw material, was at the following volume ratio:
methane gas: 4.0000 vol.%, and
hydrogen gas: 96.0000 vol.%,
a time for film formation was 100 hours, and a growth rate was 2.4 µm/h.

### (Comparative Example 1)

A diamond crystal was heteroepitaxially grown by the microwave plasma CVD method on an Ir (111) film/single crystal MgO (111) substrate manufactured as in Example 1. The Ir (111) film/single crystal MgO (111) substrate bias-treated was set in a microwave plasma CVD apparatus chamber. After it was confirmed that the base pressure had become 1×10⁻⁶ Torr (about 1.3×10⁻⁴ Pa) or lower, a temperature of the substrate was set to 830 to 1090°C, a mixed gas of methane gas and hydrogen gas, the mixed gas being a raw material, was introduced into the chamber at a flow rate of 2000 sccm at the following volume ratio:
methane gas: 3.0000 vol.%, and
hydrogen gas: 97.0000 vol.%.
After making the pressure inside the chamber 110 Torr (about 1.5×10⁴ Pa) by adjusting the aperture of the valve connected to the exhaust system, film formation was performed for 96 hours by applying a microwave of 3500W, whereby the film formation was performed until the thickness reached about 500 um (a growth rate: 5.2 µm/h. )

Accordingly, the diamond crystal was heteroepitaxial grown on the Ir (111) film/single crystal MgO (111) substrate, and thus the laminate substrate was manufactured.

Then, the Ir (111) film/single crystal MgO (111) substrate was removed to make a freestanding substrate. Firstly, the single crystal MgO (111) substrate was etched off, and then the Ir (111) film was removed by polishing. Consequently, a freestanding substrate (a diamond substrate) of an undoped single crystal diamond film with a diameter of 20 mm was obtained. The surface of the diamond substrate was scaife polishing treated to finish to a mirror surface, and then a polished nitrogen-undoped single crystal diamond substrate was obtained.

Then, the polished nitrogen-undoped single crystal diamond substrate was subjected to X-ray diffraction analysis to investigate a crystal orientation as in Example 1. A sample cross-section was also analyzed by an Electron Backscatter Diffraction method (EBSD), a type of electron diffraction method. The results of the EBSD analysis are shown in FIG. 9.

### (Comparative Example 2)

The polished nitrogen-undoped single-crystal diamond substrate was manufactured as in Comparative Example 1, except that a temperature of the substrate was set to 860 to 1060°C, and a mixed gas of methane gas and hydrogen gas, the mixed gas being a raw material, was introduced into the chamber at a flow rate of 500 sccm at the following volume ratio:
methane gas: 6.0000 vol.%, and
hydrogen gas: 94.0000 vol.%,
a film formation was performed for 20 hours, and a growth rate was 3.9 µm/h.

Conditions for film formation are shown in Table 1.

**[Table 1]**

| Conditions forCVD | Raw material gas composition Methane/Hydrogen (vol.%) | Raw material gas total flow rate (seem) | Time for film formation (h) | Growth rate (*µ*m/h) | Temperature of substrate (°C) | XRD | | Electron diffraction |
|---|---|---|---|---|---|---|---|---|
| | | | | | | Pole figure Method | Out-of-plane method (111) rocking curve half width (° ) | |
| Example 1 | 3.0/ 97·0 | 500 | 99 | 1.4 | 860-970 | (111) Orientation | 0.67 | (111) Orientation |
| Example 2 | 3.0/ 97·0 | 500 | 45 | 0.7 | 800-850 | (111) Orientation | 0.67 | (111) Orientation |
| Example 3 | 4.0/ 96·0 | 500 | 100 | 2.4 | 860-1020 | (111) Orientation | 0.75 | (111) Orientation |
| Comparative Example 1 | 3.0/ 97·0 | 2000 | 96 | 5.2 | 830-1090 | (111) Orientation and | 1.49 | Orientation changed from (111) to (001) |
| | | | | | | (001) Orientation | | |
| Comparative Example 2 | 6.0/ 94·0 | 500 | 20 | 3.9 | 860--1060 | (111) Orientation and | 1.56 | Orientation priority changed from (111) to (001) |
| | | | | | | (001) Orientation | | |

As shown in FIG. 9, the growth rate of less than 3.8 µm/h made the orientation (111) and did not make (001).

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a diamond substrate, the method being a method for producing a (111) oriented diamond crystal on an underlying substrate by epitaxial growth using hydrogen-diluted methane as a main source gas by a microwave plasma CVD method, a direct current plasma CVD method, a hot-filament CVD method, or an arc discharge plasma jet CVD method, wherein
a growth rate is less than 3.8 µm/h.

2. The method for manufacturing the diamond substrate according to claim 1, wherein
a (111) oriented nitrogen-doped diamond crystal is produced on the underlying substrate using hydrogen-diluted methane as the main source gas and adding a nitrogen gas as a dopant in accordance with the method for producing the (111) oriented diamond crystal by epitaxial growth.

3. The method for manufacturing the diamond substrate according to claim 1 or 2, wherein
a temperature of the underlying substrate being grown by the microwave plasma CVD method, the direct current plasma CVD method, the hot-filament CVD method, or the arc discharge plasma jet CVD method is within a range of 600°C to 1050°C.

4. The method for manufacturing the diamond substrate according to any one of claims 1 to 3, wherein
the underlying substrate is a single layer substrate of a single crystal diamond (111).

5. The method for manufacturing the diamond substrate according to claim 4, wherein
the underlying substrate is the single crystal diamond (111) and has a main surface that has an off angle within a range, -8.0° or more and -0.5° or less, or +0.5° or more and +8.0° or less in a crystal axis [-1-1 2] direction or a threefold symmetry direction thereof relative to a crystal plane orientation of (111) .

6. The method for manufacturing the diamond substrate according to claim 4 or 5, wherein
the underlying substrate comprising the single crystal diamond (111) is any of a high-pressure-high-temperature-synthesized single crystal diamond, a heteroepitaxial single crystal diamond, a CVD-synthesized homoepitaxial diamond, and a combined single crystal diamond thereof.

7. The method for manufacturing the diamond substrate according to any one of claims 1 to 3, wherein
the underlying substrate has a laminated structure comprising an underlayer substrate and an intermediate layer on the underlayer substrate.

8. The method for manufacturing the diamond substrate according to claim 7, wherein
the intermediate layer has an outermost surface being a metal layer selected from Ir, Rh, Pd, Pt, Cu, Ni, Fe, Cr, Mn, and Ti.

9. The method for manufacturing the diamond substrate according to claim 7 or 8, wherein
the underlayer substrate is a substrate comprising a single Si, MgO, Al₂O₃, SiO₂, Si₃N₄, SiC, Ir, Rh, Pd, Pt, Cu, Ni, Fe, Cr, Mn or Ti, or a laminated body selected from Si, MgO, Al₂O₃, SiO₂, Si₃N₄, SiC, Ir, Rh, Pd, Pt, Cu, Ni, Fe, Cr, Mn or Ti.

10. The method for manufacturing the diamond substrate according to any one of claims 7 to 9, wherein
the underlayer substrate has a main surface with a plane orientation of (111) or further includes a layer as a main surface with a plane orientation of (111) between the underlayer substrate and the intermediate layer.

11. The method for manufacturing the diamond substrate according to claim 10, wherein
the main surface with the plane orientation of (111) of the underlayer substrate has an off angle within a range, -8.0° or more and -0.5° or less, or +0.5° or more and +8.0° or less in a crystal axis [-1-1 2] direction or a threefold symmetry direction thereof relative to a crystal plane orientation of (111).

12. The method for manufacturing the diamond substrate according to any one of claims 1 to 11, wherein
a total thickness of a diamond formed on the underlying substrate is 80 to 2000 µm.

13. The method for manufacturing the diamond substrate according to any one of claims 1 to 12, wherein
a member containing Si is not used in a chamber for performing the CVD method.

14. The method for manufacturing the diamond substrate according to claim 13, wherein
sapphire is used for an observation window of the chamber for performing the CVD method.

15. The method for manufacturing the diamond substrate, wherein
a (111) oriented diamond substrate is obtained by removing the underlying substrate from a laminate substrate comprising the (111) oriented diamond crystal obtained by the method for manufacturing a diamond substrate according to any one of claims 1 to 6.

16. The method for manufacturing the diamond substrate, wherein
a (111) oriented diamond substrate is obtained by removing the underlying substrate, the underlayer substrate, or both of the intermediate layer and the underlayer substrate from a laminate substrate comprising the (111) oriented diamond crystal obtained by the method for manufacturing a diamond substrate according to any one of claims 7 to 14.

17. The method for manufacturing the diamond substrate, wherein
a surface of the (111) oriented diamond crystal obtained by the method for manufacturing a diamond substrate according to any one of claims 1 to 16 is smoothed.

18. A diamond substrate, wherein
a (111) plane diffracted peak is detected while a (111) plane is being oriented toward a substrate main surface normal direction, whereas
a (111) plane diffracted peak is undetected while a (001) plane is being oriented toward a substrate main surface normal direction, wherein
an X-ray diffractometer is used by a pole figure method with an anticathode Cu being used as an X-ray generator under a condition of a power 45 kV of 200 mA, an evaluating diffracted plane (111), a diffracted angle 2Θ = 43.9°, and a step size of 1°.

19. The diamond substrate according to claim 18, wherein
a rocking curve half width of the diamond substrate is 0.90° or less, wherein
an X-ray diffractometer is used by an Out-of-plane method with an anticathode Cu being used as an X-ray generator under a condition of a power 45 kV of 200 mA, an evaluating diffracted plane (111), a diffracted angle 2θ = 43.9°, and a step size of 0.001°.
